# DEMANDE DE BREVET EUROPEEN

(11) **EP 4 024 708 A1**
(43) Date de publication de la demande: **06.07.2022**
(21) Numéro de dépôt: 21217943.6
(22) Date de dépôt: 28.12.2021
(51) Int. Cl.: H03K 5/24, G01R 19/165, G01R 31/00, H03K 17/18, H03K 5/08, H03K 19/003

(54) **INTERFACE DISCRETE CONFIGUREE POUR GERER AU MOINS DEUX ETATS ACTIFS ET UN ETAT INACTIF DANS UN EQUIPEMENT**

(30) Priorité: 30.12.2020 FR 2014249
(71) Demandeur: THALES, 92400 Courbevoie (FR)
(72) Inventeur: ZIN, Guillaume, 49309 Cholet (FR); LEOSTIC, Lilian, 49309 Cholet (FR)
(74) Mandataire: Marks & Clerk France

(57) **Abrégé**

L'invention concerne une nouvelle interface basée notamment sur l'utilisation d'un montage faible consommation à base de comparateur à fenêtre (100, 200) avec une polarisation milieu par défaut à l'intérieur de la fenêtre (12, 13). Le réglage des seuils de la fenêtre permettra notamment de définir des deux états actifs « V+ » et GROUND dans le cas du standard précité, ou de deux états actifs par exemple.

## Description

L'invention concerne une interface discrète dans le domaine de l'électronique avionique interopérable dynamiquement entre au moins deux états actifs V+/Ouvert(Open) et Ouvert/Masse(Ground), où V+ désigne une tension d'alimentation nominale d'un équipement.

Par exemple, l'interface selon l'invention trouve son application pour les standards 28 V/Ouvert et Ouvert/Masse dans le domaine de l'aéronautique. L'état Ouvert est considéré comme un état inactif. Elle est notamment compatible d'un fonctionnement permanent sur pile du fait de sa faible consommation.

Elle peut aussi être mise en œuvre dans d'autres domaines techniques, par exemple dans le domaine automobile.

Elle trouve notamment son application pour des équipements fonctionnant sur batterie ou pour des équipements ayant des besoins en Interface Homme Machine avec effacement d'urgence des données, par exemple des chiffreurs de données.

L'art antérieur, par exemple le brevet US10365304, décrit des dispositifs permettant d'assurer l'interface indifféremment avec un dispositif 28V/Ouvert ou un dispositif Ouvert/Masse. Le dispositif ne traite pas le problème de la basse consommation nécessaire dans certains cas d'utilisation.

A la connaissance du demandeur, les interfaces disponibles dans l'art antérieur ne permettent pas de répondre à l'ensemble des problèmes techniques suivants :
- Assurer une faible consommation, afin d'augmenter la durée de vie de la batterie ou de la pile fournissant l'énergie aux différents équipements,
- Offrir une modularité importante, i.e., l'interface pouvant être activée sur différents niveaux en fonction du porteur sur lequel l'équipement est installé,
- Offrir une compatibilité dynamique avec les standards et la robustesse demandés dans le domaine de l'aéronautique ou dans des domaines similaires, par exemple, avec un standard 28V, une protection contre la foudre, etc.

L'idée de la présente invention est de proposer une nouvelle interface basée notamment sur l'utilisation d'un montage comparateur à fenêtre avec une polarisation milieu par défaut à l'intérieur de la fenêtre. Le réglage des seuils de la fenêtre permettra notamment de définir les seuils de commutation selon l'un ou l'autre des deux états actifs V+ (alimentation nominale de l'équipement) et la masse Ground.

Dans la suite de la description, on utilise les termes suivants : Ground pour désigner la masse, Open pour désigner l'état ouvert et V+ pour désigner l'alimentation nominale d'un équipement. Les termes « batterie » et « pile » désignent un même élément.

L'invention concerne une interface destinée à être disposée entre un premier dispositif et un deuxième dispositif prenant en entrée au moins deux états actifs et un état inactif, l'interface comporte au moins les éléments suivants :

- Une première voie comprenant au moins un premier comparateur ayant un seuil de comparaison fixé par rapport à un premier état actif V₁ et une deuxième voie comprenant un deuxième comparateur ayant un seuil de comparaison fixé en fonction d'un deuxième état actif V₂, le premier comparateur et le deuxième comparateur sont disposés en parallèle,

- La sortie du premier comparateur et la sortie du deuxième comparateur sont reliées à un dispositif logique configuré pour générer un état actif lorsque la tension appliquée sur l'entrée de l'interface est égale au premier état actif V₁ ou lorsque la tension appliquée sur l'entrée de l'interface est égale au deuxième état actif V₂.

L'interface est caractérisée en ce qu'elle comporte au moins un étage de mouillage et de polarisation milieu composé d'au moins une résistance de polarisation, d'une diode et d'une tension de référence V_{ref2} provenant d'une source d'alimentation permanente, ledit étage de mouillage et de polarisation étant disposé en amont d'un des comparateurs.

L'interface peut comporter en outre un bloc de mouillage situé en amont de l'étage de mouillage et de polarisation milieu, ledit bloc est composé d'une tension de référence V_{ref1} fournissant un courant de polarisation, d'une résistance de réglage et d'une diode d'isolation.

L'interface comporte, par exemple, un filtre configuré pour éviter les perturbations électromagnétiques, ledit filtre étant disposé en amont d'un pont diviseur.

La sortie du premier comparateur et la sortie du deuxième comparateur sont chacune reliées à un filtre configuré pour éviter les phénomènes de pointe de tension ou d'impulsion inopinée ou « glitch ».

L'interface peut aussi comporter une protection contre la foudre disposée en amont du filtre contre les perturbations électromagnétiques CEM.

Dans un mode d'application, le premier état correspond à la masse Ground, le deuxième état est un état de 28V, le troisième état inactif est un état « Open ».

D'autres caractéristiques, détails et avantages de l'invention ressortiront à la lecture de la description faite en référence aux dessins annexés donnés à titre d'exemples illustratifs et non limitatifs et qui représentent, respectivement :
[Fig.1], un schéma bloc de l'interface selon l'invention,
[Fig.2], un schéma détaillé de l'étage de protection, suivi de l'étage de filtrage, et enfin de l'étage de mouillage sur tension bord équipement,
[Fig.3], un schéma détaillé de l'étage de mouillage sur tension permanente, ainsi que de l'étage de comparaison et de sortie du montage.

Afin de bien faire comprendre l'objet de l'invention, l'exemple détaillé qui suit concerne une interface permettant une compatibilité dynamique avec deux standards V+=28V/Open et Open/Ground habituellement utilisés dans le domaine de l'aéronautique. Les explications qui vont suivre peuvent s'appliquer pour différentes valeurs de tension correspondant à un état actif d'un système et dans d'autres domaines techniques que celui de l'aéronautique.

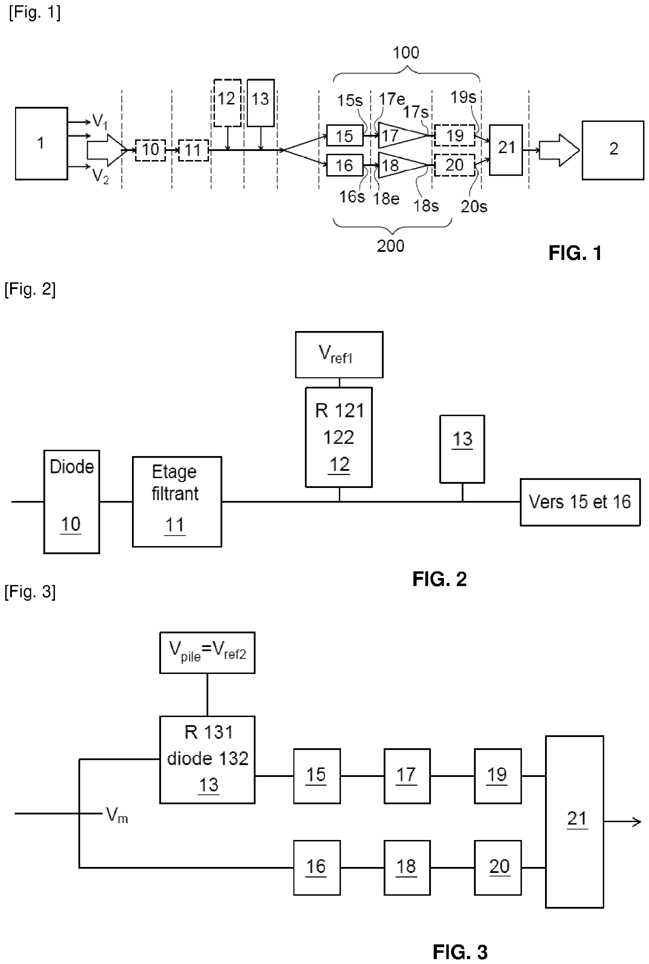

La figure 1 est un schéma bloc permettant de décrire les éléments caractéristiques de l'interface selon l'invention. Sur la figure 1, les blocs en pointillés représentent des modules et des fonctions optionnelles de l'interface selon l'invention.

L'interface selon l'invention sera disposée entre un premier dispositif 1 générant au moins deux états actifs (deux tensions différentes V₁, V₂) et un deuxième dispositif 2 qui va accepter en entrée au moins un de ces deux états.

Les valeurs de tension correspondantes aux états de fonctionnement du dispositif, par exemple, V₁, V₂ et open (état inactif), sont transmises à un premier module optionnel 10 de protection contre la foudre. Le module de protection contre la foudre est, par exemple, une diode de suppression des tensions transitoires TVS dont la tension de limitation (Reverse Stand-Off Voltage) est choisie de façon à ne pas empêcher la présence d'une tension 28V de façon continue sur l'entrée de l'interface. Cette valeur sera choisie plutôt élevée pour rester compatible d'une norme donnée (par exemple supérieure à 32V). Ceci permet aussi de maintenir un courant de fuite vers la masse assez faible afin de limiter la décharge de la pile.

En sortie de diode TVS, le signal est transmis à un filtre optionnel, 11, contre les phénomènes électromagnétiques, aussi appelé couramment « filtre CEM ». L'étage de filtrage comprend plusieurs éléments passifs. L'ensemble des éléments passifs doit présenter une impédance série faible, d'une centaine d'ohms maximum, de façon à ne pas perturber le reste du montage. Le filtre sera constitué de composants passifs choisis pour limiter au maximum le courant de fuite vers la masse. Ceci permet de limiter la décharge de la pile lorsque la source alimentant le dispositif est une pile. Un composant passif est, par exemple, une résistance, une inductance, une ferrite, un condensateur.

En sortie de filtre, il est possible d'appliquer une tension de mouillage optionnelle. Le dispositif comprend un module optionnel de mouillage/polarisation 12.

Ce module optionnel de mouillage/polarisation sur tension de bord équipement ON, référencé 12, permet notamment d'assurer un courant de mouillage important dès lors que la tension de bord est présente, pour ne pas prendre ce courant de mouillage sur la tension de pile. La valeur de courant est par exemple comprise entre 3 et 10 mA. Ce bloc optionnel est disposé entre la sortie de l'étage de filtrage et les ponts diviseurs numéroté 15 et 16.

Le module de mouillage/polarisation 12 assure un courant de mouillage Iₘₒₚₜ optionnel qui fonctionne lorsque l'équipement est alimenté. Le module de tension de polarisation milieu 13 assure un courant de polarisation Iₚ qui fonctionne lorsque l'équipement est alimenté et sur pile.

L'utilisation d'un rail d'alimentation de l'équipement ON permet d'avoir un courant de mouillage beaucoup plus important sans risque de diminuer la réserve d'énergie de la pile, i.e., de la source d'alimentation permanente de type pile batterie et dont l'énergie doit être économisée dans la mesure du possible.

Concernant la tension de mouillage des modules 12 ou 13, on choisit une tension Vₘ amenant un état par défaut, considéré « open » par les deux étages de comparaison 100, 200, comprenant un premier pont diviseur 15 et un premier comparateur 17, et un deuxième pont diviseur 16 et un deuxième comparateur 18.

La valeur de résistance 131 (figure 3) présente dans le module de mouillage 13 est choisie de façon à limiter le courant de polarisation Iₚ à 15µA, par exemple. Ceci, toujours dans un but de réduire la consommation sur la pile et l'usure prématurée.

Une chaîne de comparaison comprend, par exemple, un premier pont diviseur 15 et un deuxième pont diviseur 16 qui sont disposés en parallèle et en aval du module de filtrage CEM. Ces deux ponts diviseurs permettent notamment d'adapter le niveau de l'interface entrante à celui des seuils fixés au niveau de chaque comparateur disposé en aval. Le montage permet ainsi de mesurer des niveaux actifs à 28V, même sur une tension de pile plus basse.

Les ponts diviseurs sont constitués de plusieurs résistances. Les valeurs des résistances sont fixées de façon à limiter le courant de fuite et à maintenir une impédance d'entrée importante face aux résistances des blocs de polarisation.

Dans le cas de la branche de mesure du niveau actif de 28V, une diode de type Zener DZ est ajoutée pour diminuer la valeur de tension avant le pont diviseur, comme il sera détaillé à la figure 2.

Au niveau de chacune des branches de mesure de l'état (tension), la sortie 15s du premier pont diviseur 15 et la sortie 16s du deuxième pont diviseur 16 sont reliées respectivement à une entrée 17e du premier comparateur 17 et à une entrée 18e du deuxième comparateur 18.

Les caractéristiques techniques des comparateurs sont notamment choisies, pour leur tenue en température et leur faible consommation car ils sont alimentés par la tension pile. Les impédances d'entrée des deux comparateurs sont bien supérieures aux impédances d'entrée des ponts diviseurs.

La valeur de seuil de comparaison Vₛₑᵤᵢₗ₁ et Vₛₑᵤᵢₗ₂ pour chacun des comparateurs est fixée, par exemple selon la tension pile fournie et conjointement avec les ratios fixés par les ponts diviseurs. Par exemple, pour un comparateur alimenté par une tension pile de 5V, on prendra un ratio de division par 10, ce qui amènera une tension de comparaison à 2,8V pour une entrée à 28V. On prendra une première valeur seuil Vₛₑᵤᵢₗ₁ pour détecter l'état V₁ et une deuxième valeur seuil Vₛₑᵤᵢₗ₂ pour la détection du deuxième état V₂. Par exemple, pour une tension de 28V, on va choisir un seuil permettant une détection à partir de 12V ; pour la masse, on choisira par exemple un seuil en dessous de 4V.

La sortie 17s, 18s, de chacun des comparateurs 17, 18 peut être connectée à un filtre respectivement 19, 20 combattant les fluctuations de type « glitchs ». Ce filtre est composé de composants passifs.

Les sorties 19s, 20s de ces deux filtres optionnels 19, 20 sont reliées à une entrée 21e d'un module « OU » logique de sortie 21.

Ce module « OU » logique, en coopération avec la polarisation milieu réalisée à l'aide du module de mouillage permet la compatibilité dynamique avec les standards 28V/Open et Open/Ground. Le module « OU » logique est, par exemple, une fonction NAND avec des transistors drain ouvert et un tirage haut de type résistif qui sera choisi de façon à limiter le courant consommé sur la pile. L'opération logique réalisée par le module « OU » logique rend la sortie active si l'une ou l'autre des deux branches de détection a vu un niveau actif 28V ou GROUND sur l'entrée de l'interface. La sortie du « OU » logique est reliée au deuxième dispositif 2 qui s'interface avec le premier dispositif 1.

La figure 2 illustre un exemple de réalisation du bloc de mouillage sur tension bord équipement ON. Ce bloc optionnel est disposé en « sortie » de l'étage de filtrage 11, avant les ponts diviseurs 15, 16.

Ce bloc de mouillage 12 est constitué de trois éléments : une tension de référence V_{ref1}, une résistance de réglage 121 et une diode d'isolation 122.

La résistance de réglage 121 permet de régler la quantité de courant fourni par la référence de tension.

La diode d'isolation 122 permet d'éviter toute perturbation du montage lorsque la polarisation n'est pas présente (équipement sur batterie uniquement). Aussi, elle force le sens du courant dans un seul et unique sens.

La tension de référence V_{ref1} fournit le courant Iₚ pour la polarisation. Son niveau de tension est choisi de façon à ne pas forcer un niveau actif sur l'interface (donc supérieur au seuil actif bas, et inférieur au seuil actif haut).

L'utilisation d'un rail d'alimentation de l'équipement ON permet d'avoir un courant de mouillage beaucoup plus important, sans risque de diminuer la réserve d'énergie de la pile.

La figure 3 illustre un exemple de réalisation de l'étage de mouillage et de polarisation milieu 13, pour un équipement dans un état OFF. Cet étage comporte par exemple une résistance de polarisation 131, une diode 132 et une tension de référence V_{ref2}.

La tension de référence V_{ref2} provient de la source permanente, c'est-à-dire de la batterie. A ce titre, la résistance de polarisation 131 sera choisie assez grande pour pouvoir minimiser le courant de fuite (interface en mode Open) et permettre tout de même un peu de courant de mouillage (interface Ground). Pareillement, le niveau de tension de la référence de tension, sera choisi de telle sorte qu'aucun des montages aval ne détecte un niveau actif sur l'interface.

La valeur de la résistante 131 est par exemple choisie afin qu'elle soit assez inférieure à l'impédance du pont diviseur 15 qui suit, pour ne pas perturber le ratio de division. En effet, même en cas d'absence d'une polarisation milieu en mode « Open » par la tension de l'équipement ON, on maintient une polarisation avec la pile. Le courant disponible étant faible, l'idée est de limiter les courants de fuite du reste du montage pour ne pas décharger la pile trop rapidement.

La diode 132 permet d'éviter toute perturbation du montage lorsque la polarisation n'est pas présente (équipement sur batterie uniquement). Aussi, elle force le sens du courant dans un seul et unique sens.

L'interface selon l'invention offre notamment une interface interopérable dynamiquement entre au moins deux états actifs et un état inactif. L'interface permet avantageusement de gérer l'interface standard V+/Open et l'interface Ground/Open. Elle offre aussi une consommation compatible d'une batterie ou d'une pile grâce à une faible consommation de fonctionnement.

## Revendications

1. Interface disposée entre un premier dispositif (1) et un deuxième dispositif (2) prenant en entrée au moins deux états actifs, un état inactif, comportant au moins les éléments suivants :
- une première voie (100) comprenant au moins un premier pont diviseur (15), un premier comparateur (17) ayant un seuil de comparaison fixé par rapport à un premier état actif V₁ et une deuxième voie (200) comprenant au moins un pont diviseur (16), un deuxième comparateur (18) ayant un seuil de comparaison fixé en fonction d'un deuxième état actif V₂, le premier comparateur et le deuxième comparateur sont disposés en parallèle,
- la sortie (17s) du premier comparateur (17) et la sortie (18s) du deuxième comparateur (18) sont reliées à un dispositif logique (21) configuré pour générer un état actif lorsque la tension appliquée sur l'entrée de l'interface est égale au premier état actif V₁ ou lorsque la tension appliquée sur l'entrée de l'interface est égale au deuxième état actif V₂,
**Caractérisée en ce qu'**elle comporte au moins un étage de mouillage et de polarisation milieu (13) composé d'au moins une résistance de polarisation (131), d'une diode (132) et d'une tension de référence V_{ref2} provenant d'une source d'alimentation permanente, ledit étage de mouillage et de polarisation (13) étant disposé en amont d'un des comparateurs.

2. Interface selon la revendication 1 **caractérisée** en qu'elle comporte en outre un bloc de mouillage (12) situé en amont de l'étage de mouillage et de polarisation milieu (13) composé d'une tension de référence V_{ref1} fournissant un courant de polarisation, d'une résistance de réglage (121) et d'une diode d'isolation (122).

3. Interface selon l'une des revendications 1 ou 2 **caractérisée en ce qu'**elle comporte un filtre (11) configuré pour éviter les perturbations électromagnétiques, ledit filtre étant disposé en amont des ponts diviseurs (15, 16).

4. Interface selon l'une des revendications précédentes **caractérisée en ce que** la sortie (17s) du premier comparateur (17) et la sortie (18s) du deuxième comparateur (18) sont reliées chacune à un filtre (19, 20) configuré pour éviter les phénomènes de glitch.

5. Interface selon l'une des revendications précédentes **caractérisée en ce qu'**elle comporte en amont du filtre (11) une protection (10) contre la foudre.

6. Interface selon l'une des revendications précédentes **caractérisée en ce que** le premier état correspond à la masse « Ground », le deuxième état est un état de 28V, le troisième état inactif est un état « Open ».
